# DEMANDE DE BREVET EUROPEEN

(11) **EP 3 113 305 A1**
(43) Date de publication de la demande: **04.01.2017**
(21) Numéro de dépôt: 15306081.9
(22) Date de dépôt: 02.07.2015
(51) Int. Cl.: H01S 5/22

(54) **HÉTÉROSTRUCTURE SEMI ISOLANTE ENTERRÉE**

(71) Demandeur: ALCATEL LUCENT, 92100 Boulogne-Billancourt (FR)
(72) Inventeur: KAZMIERSKI, Christophe, 91420 MORANGIS (FR); ALEXANDRE, François, 94400 VITRY (FR); GARREAU, Alexandre, 91460 MARCOUSSIS (FR)
(74) Mandataire: Berthier, Karine

(57) **Abrégé**

Le dispositif optoélectronique intégré de structure de type SIBH comprend au moins une section pilotée en courant et une section pilotée en tension. La section pilotée en courant comporte une couche bloquante entre le matériau InP dopé au fer (InP:Fe) et le matériau InP de type p (p-InP) comprenant une première couche de matériau InP dopé au ruthénium (InP:Ru) d'épaisseur inférieure à 1 µm et une deuxième couche de matériau de type n d'épaisseur inférieure à 0,5 µm. La section pilotée en tension comporte une couche bloquante entre le matériau InP dopé au fer (InP:Fe) et le matériau InP de type p (p-InP) comprenant seulement une couche de matériau InP dopé au ruthénium (InP:Ru) d'épaisseur inférieure à 1 µm.

## Description

### DOMAINE

La présente invention se rapporte au domaine des télécommunications numériques haut débit, et notamment à celui des dispositifs d'émission optique comprenant un composant intégré comportant au moins une section laser d'émission et une section de modulation de la puissance optique émise par le laser.

### ARRIERE PLAN

Il est possible de réaliser un composant intégré comportant, sur le même substrat, une section laser d'émission et une section de modulation de la puissance optique émise par le laser. Le laser est piloté par un courant et le modulateur est commandé par un signal de tension. La section laser et la section modulateur ont la même structure enterrée, c'est à dire entièrement entourées par un milieu d'indice de réfraction plus faible, par exemple le phosphure d'indium InP. Cette structure est appelée SIBH (« Semi-Insulating Buried Heterostructure » en anglais).

Dans le domaine des télécommunications par fibre optique, les hétérostructures semi-isolantes enterrées SIBH sont couramment utilisées dans les circuits intégrés photoniques PIC (« Photonic Integrated Circuit » en anglais) à base de phosphure d'indium InP pour les émetteurs à haute performance, notamment en environnement peu ou pas refroidi, ou les modulateurs à haut débit. Les structures SIBH présentent comme avantage majeur de réduire simultanément la capacité parasite, la résistance série et la résistance thermique par rapport aux autres technologies de guide d'onde actif. Les structures SIBH connues, utilisées séparément dans des modulateurs ou des lasers discrets, ont montré leur efficacité.

Les structures SIBH sont habituellement basées sur le phosphure d'indium InP de type n dopé au fer (InP:Fe) car la croissance de ce matériau est facile. Il présente une résistivité élevée nécessaire pour bloquer les courants parasites sur les bords du guide d'onde, et une faible capacité parasite due aux propriétés diélectriques de l'InP:Fe. Toutefois ce matériau ne peut être mis en directement en contact avec des couches de diode de type p (dopées par Zn, Be ou un autre accepteur) à cause du phénomène d'interdiffusion. Le phénomène d'interdiffusion est la diffusion rapide du fer et de l'accepteur vers la couche voisine jusqu'à une distance supérieure à l'épaisseur total de l'empilement des couches de confinement de type p et semi-isolantes, par exemple de l'ordre de 10 µm) dans des conditions de temps et de température typiques de la croissance épitaxiale.

Un guide formant une diode p-n avec une telle structure SIBH présente un courant de fuite latéral important lorsqu'on lui applique une tension positive. Le courant de fuite est dû à une décroissance rapide de la résistivité de la couche de confinement latéral. La décroissance de la résistivité résulte de l'interdiffusion des dopants p de la couche de confinement vertical et des dopants de la couche de confinement latéral semi-isolante, pendant l'étape de réalisation de la couche de confinement vertical. Ce courant de fuite dégrade de façon sensible les performances du SIBH. En conséquence les structures SIBH comportent habituellement une couche de blocage de l'interdiffusion entre le InP:Fe et le InP de type p. Cette couche bloquante est indispensable à l'obtention de composants lasers ayant des performances élevées et reproductibles.

Les couches bloquantes connues appartiennent à deux catégories :
- en matériau de type n, de préférence n-InP dans la mesure où ce matériau n'introduit pas de sauts d'indice optique supplémentaires dans le guide d'onde. D'autres sortes de matériau de type n ont aussi été proposés, tel que n-GaInAsP, en particulier pour la facilité d'élimination de la couche bloquante si nécessaire. La couche bloquante de type n apparait comme très efficace pour les lasers et les autres composants à guide d'onde pilotés par le courant directement polarisés. En revanche, la présence d'une jonction p-n distribuée sur les côtés du guide d'onde introduit une capacité parasite additionnelle prohibitive pour les modulateurs à haut débit pilotés par la tension polarisés en inverse.
- en matériau différent du matériau semi-isolant InP:Fe, et préférentiellement à base d'InP ou encore un matériau composite semi-isolant, tel que GaAIAs non dopé connu pour sa haute résistivité. Cependant, il ya des problèmes d'adaptation de la constante du réseau cristallin sur InP, avec des sauts d'indice optique non désirés et avec le traitement du composants qui comprend une matière à base d'aluminium hautement réactif.

Ces deux solutions pour des couches bloquantes ont été utilisées en intégration photonique. Par exemple la couche bloquante de type n a été appliquée à des composants pilotés par la tension qui ont vu leur débit limité.

Enfin une troisième solution a été tentée pour fournir différentes structures pour les composants/sections pilotés en courant/tension. Cette solution est basée sur la suppression de la couche bloquante de type n pour les composants/sections pilotés en tension, de manière à conserver un procédé simple et la croissance d'un seul matériau semi-isolant enterré, Le principal inconvénient de cette solution est que, sans la couche bloquante de type n, l'interdiffusion de Zn-Fe se produit dans ces parties du circuit PIC, et affecte partiellement ou complètement les propriétés attendues des jonctions p-n, incluant une capacité parasite augmentée.

### RESUME

Les récents développements de la technologie d'intégration monolithique sur InP permettent d'inclure plusieurs types de composants actifs comportant des jonctions p-n sur une même puce. En conséquence le besoin d'un type unique de structure SIBH se fait sentir afin de simplifier le procédé de fabrication et d'améliorer son rendement.

En dépit de tentatives récentes, les structures obtenues sont difficiles à améliorer et ne sont pas suffisamment efficaces pour permettre de polariser directement et de polariser en sens inverse des composants sur la même puce.

Il s'agit donc de proposer une solution simple pour l'intégration de diodes actives à guide d'onde pilotées directement avec un courant (laser, SOA) ou polarisées inversement par une tension (modulateurs electro-optiques ou à électro-absorption).

L'objet de la présente invention est un dispositif optoélectronique intégré de structure de type SIBH comprenant au moins une section pilotée en courant et une section pilotée en tension, la section pilotée en courant comportant une couche bloquante entre le matériau InP dopé au fer (InP:Fe) et le matériau InP de type p (p-InP), caractérisé en ce que la couche bloquante comprend une première couche de matériau InP dopé au ruthénium (InP:Ru) d'épaisseur inférieure à 1 µm et une deuxième couche de matériau de type n d'épaisseur inférieure à 0,5 µm.

Une des propriétés du phosphure d'indium dopé au ruthénium InP:Ru est sa bonne résistivité (supérieure à 10⁵ Ohm.cm, et de préférence supérieur à 10⁸ Ohm.cm) et sa bonne efficacité de blocage de la diffusion du Zn. Toutefois ce matériau est difficile à faire croître et exige une grande précision des paramètres de croissance conduisant à de faible tolérance du procédé. Cela conduit à un rendement de fabrication faible, spécialement en cas d'intégrations de PICs à grande échelle. En outre InP:Ru utilisé seul ne supprime pas complètement le problème de fuite de courant dans les composants pilotés en courant, et il est sujet à une concentration élevée de niveaux profonds produisant un effet dit « de double injection » qui aggrave les problèmes de fuite de courant des composants pilotés en courant directement polarisés. A la différence d'un matériau bloquant de type n, le matériau InP:Ru est adapté aux composants commandés en tension car il n'introduit pas de jonction p-n ou de capacité supplémentaire.

Dans le cas d'une couche bloquante épaisse de InP:Ru, remplaçant InP:Fe, l'inconvénient de l'interdiffusion est supprimé. Cependant une couche bloquante épaisse de InP:Ru est difficile à faire croître en gardant le contrôle de la qualité du cristal et sa bonne résistivité. En conséquence une seule couche bloquante mince de InP:Ru (< 1 µm) obtenue par croissance sur InP:Fe à haute résistivité n'est pas suffisante pour réaliser des composants de haute qualité pilotés en courant reproductibles, en raison de l'augmentation des fuites de courant dues à l'effet « de double injection ».

La solution proposée ici est une couche bloquante, recouvrant la couche InP:Fe à haute résistivité. Dans la section pilotée en courant, la couche bloquante comprend une première couche mince semi-isolante de InP:Ru (< 1 µ) recouverte d'une deuxième couche mince de type n (< 0,5 µ) comme n-InP ou un matériau composite par exemple quaternaire.

Cette deuxième couche mince de type n améliore le blocage du courant de fuite et peut donc être très mince (< 0.5 µ), et de préférence de l'ordre de 0,1 µm, afin de limiter l'impact indésirable d'un saut d'indice dans la conception du guide d'onde.

Selon une variante, la deuxième couche mince de type n est en InGaAsP (Indium-Gallium-Arsenic-Phosphore).

Selon une autre variante, la deuxième couche mince de type n est en un matériau ayant un réseau cristallin adapté au réseau cristallin du matériau du substrat, par exemple le matériau quaternaire InGaAsP, afin de rendre plus facile son élimination par gravure sélective.

Selon un mode de réalisation du dispositif optoélectronique, la section pilotée en tension comporte une couche bloquante entre le matériau InP dopé au fer (InP:Fe) et le matériau InP de type p (p-InP), la couche bloquante comprenant une couche de matériau InP dopé au ruthénium (InP:Ru) d'épaisseur inférieure à 1 µm. La couche bloquante comprend seulement une couche mince semi-isolante de InP:Ru dans la section de modulation.

Par conséquent, la deuxième couche mince de type n bloquant l'interdiffusion améliore la propriété de blocage du courant de la section pilotée en courant, et la couche mince semi-isolante de InP:Ru est préservée dans la section pilotée en tension pour constituer une barrière d'interdiffusion.

Avantageusement la couche diélectrique InP:Fe est épaisse (e.g. 1-10 µm) en raison de sa haute résistivité bien contrôlée, et des conditions tolérantes de sa croissance épitaxiale.

L'invention a aussi pour objet un procédé de fabrication du dispositif optoélectronique précédemment décrit, comprenant les étapes suivantes :
- réalisation d'une couche de confinement inférieur et d'un guide d'onde au moyen d'une première croissance épitaxiale sur un substrat, suivie d'une gravure de la couche de confinement inférieur et du guide d'onde,
- réalisation de l'empilement d'une couche de confinement latéral, d'une première couche de matériau InP:Ru et d'une deuxième couche de matériau p-InP au moyen d'une seconde croissance épitaxiale,
- élimination de la deuxième couche de matériau de type n dans la zone de la structure correspondant à la section pilotée en tension,
- réalisation d'une couche de confinement vertical dopée p au moyen d'une troisième croissance épitaxiale..

De préférence l'élimination de la deuxième couche de matériau de type n dans la section de modulation est réalisée par gravure chimique ou bien par gravure sèche ou ionique.

### BREVE DESCRIPTION

D'autres caractéristiques et avantages apparaîtront à la lecture de la description qui suit d'un mode de réalisation, donné bien entendu à titre illustratif et non limitatif, et dans le dessin annexé sur lequel
- la figure 1 illustre une vue en coupe transversale perpendiculairement à la direction de propagation du guide d'ondes d'une SIBH connue de la section pilotée en courant,
- la figure 2 illustre une vue en coupe transversale perpendiculairement à la direction de propagation du guide d'ondes d'une SIBH connue de la section pilotée en tension,
- la figure 3 illustre une vue en coupe transversale perpendiculairement à la direction de propagation du guide d'ondes d'un mode de réalisation d'une SIBH selon l'invention de la section pilotée en courant,
- la figure 4 illustre une vue en coupe transversale perpendiculairement à la direction de propagation du guide d'ondes d'un mode de réalisation d'une SIBH selon l'invention de la section pilotée en tension,
- la figure 5 illustre une vue en coupe longitudinale le long du guide d'ondes dans la zone des couches de confinement latéral semi-isolantes d'un dispositif intégré comportant des sections pilotées en courant et en tension.
- la figure 6 illustre une vue en perspective le long du guide d'ondes dans la zone des couches de confinement latéral semi-isolantes d'un dispositif intégré comportant des sections pilotées en courant et en tension,
- les figures 7a, 7b et 7c illustrent le procédé de réalisation d'un dispositif optoélectronique intégré à structure SIBH comportant des sections pilotées en courant et en tension respectivement.

La terminologie directionnelle comme gauche/droite, haut/bas, avant/arrière, vertical/horizontal, dessus/dessous, etc... est utilisée en référence à l'orientation des figures ici décrites. Parce que les éléments composant les modes de réalisation de la présente invention peuvent être placés dans des orientations différentes, la terminologie directionnelle n'est utilisée ici qu'à des fins d'illustration et n'est nullement limitative.

### DESCRIPTION DETAILLEE

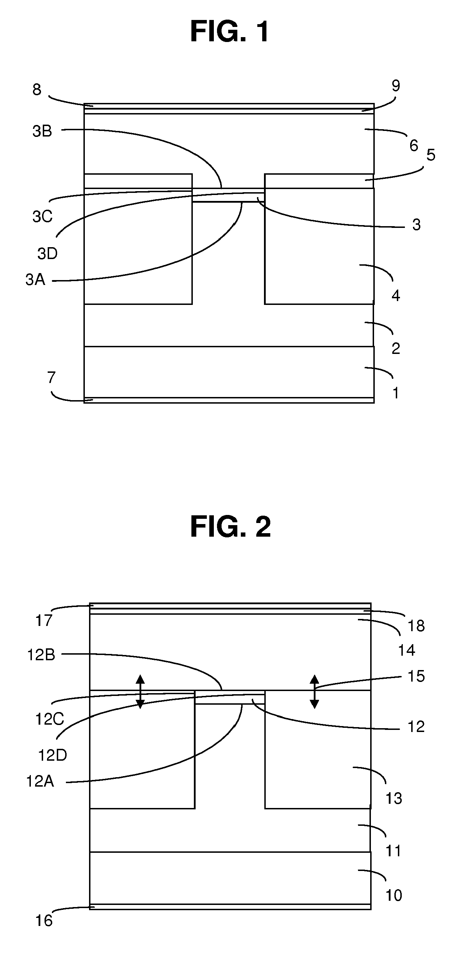

Dans le mode de réalisation illustré sur la figure 1, la section pilotée en courant d'une structure SIBH connue est construite avec une couche bloquant l'interdiffusion entre le matériau InP:Fe et-le matériau InP de type p.

Une héterostructure semi-isolante enterrée SIBH comprend un substrat semiconducteur **1,** par exemple en n-InP ou SI-InP (SI : Semi-Isolant), qui est recouvert d'une couche de confinement inférieur **2** en n-InP dopé au silicium In:Si, la face inférieure de cette couche de confinement **2** reposant sur le substrat semi-conducteur **1.** La couche de confinement inférieur **2** est surmontée d'un guide d'onde formant un ruban enterré **3** en matériau actif d'émission laser qui peut être composé d'une seule couche ou d'un empilement de plusieurs couches formant une structure active dite à "puits quantiques", c'est-à-dire une structure comportant des couches ou formes alternées minces de deux types de matériaux ou plus, l'un ayant une bande d'énergie interdite inférieure aux autres (massive, « quantum well », « quantum dots », quantum wire » ou analogue). La composition du matériau actif détermine la longueur d'onde d'émission du laser, généralement située dans le proche infrarouge pour des applications en télécommunications.

Le ruban enterré actif **3** comporte une face inférieur **3A** au contact de la couche de confinement inférieur **2,** une face supérieure **3B** qui lui est parallèle et deux faces latérale **3C** et **3D** qui sont perpendiculaires aux faces **3A** et **3B.** Des couches de confinement latéral semi-isolantes **4** sont au contact des faces **3C** et **3D** du ruban **3.** Les couches de confinement latéral semi-isolantes **23** sont constituées par exemple d'une couche épaisse de InP:Fe (e.g. 1-10µm).

La couche de confinement supérieur **5** est en InP de type p (typiquement dopée au zinc) comme par exemple en p-InP, InP:Zn. La couche de confinement supérieur **5** recouvre la face **3B** du ruban actif **3.** En général, la couche active est non intentionnellement dopée. En outre, l'une des couches de confinement est dopée n (couches de confinement inférieur **2**) et l'autre couche de confinement est dopée p (couche supérieure **5**) afin de réaliser une jonction p-n.

Une couche bloquante **6** est disposée de part et d'autre de la face supérieure **3B** du ruban enterré actif **3,** entre la couche semi-isolante de confinement latéral **4** et la couche de confinement supérieur **5.** La couche bloquante **6** limite l'interdiffusion des dopants entre les couches de confinement latéral **4** et supérieur **5.** Elle permet de préserver le caractère semi-isolant de la couche de confinement latéral **4** sans introduire de capacité parasite ou de résistance supplémentaire. Le plus souvent cette couche bloquante est en matériau semiconducteur de type n qui peut être composée d'une seule couche ou d'un empilement de plusieurs couches. Son épaisseur est typiquement de quelques dixièmes de micron.

La structure est pilotée par deux électrodes, une électrode inférieure **7** disposée sous le premier substrat **1** et une électrode supérieure **8** disposée sur la couche de confinement supérieur **5** de type p, afin d'amener le courant nécessaire au fonctionnement du laser. Pour réduire la résistivité de l'électrode supérieure **8,** une couche conductrice de contact **9** de la structure SIBH est disposée entre la couche de confinement supérieur **5** et l'électrode supérieure **8** métallique. La couche conductrice de contact **9** peut être par exemple en InGaAs dopé p.

Il faut noter que dans le cas d'un substrat semi-isolant SI-InP, la couche de contact **9** doit se situer sur les côtés de la structure SIBH, directement sur la couche de confinement inférieur **2,** de manière à être dans une zone dégagée et éloignée du guide d'onde actif **3** afin de ne pas le perturber.

On considérera maintenant la figure 2 qui illustre la section pilotée en tension d'une structure SIBH connue.

La structure SIBH comprend un substrat semiconducteur **10** de type n, par exemple en n-InP ou SI-InP, qui est recouvert d'une couche de confinement inférieur **11** en n-InP dopé au silicium In:Si, la face inférieure de cette couche de confinement **11** reposant sur le substrat **10.** La couche de confinement **11** est surmontée d'un ruban enterré **12** en matériau actif de modulation. Le ruban actif **12** comporte une face inférieur **12A** au contact de la couche de confinement **11,** une face supérieure **12B** qui lui est parallèle et deux faces latérale **12C** et **12D** qui sont perpendiculaires aux faces **12A** et **12B.** Des couches de confinement latéral semi-isolantes **13** sont au contact des faces **12C** et **12D** du ruban **12.** Une couche de confinement supérieur **14** en InP de type p recouvre la face **12B** du ruban actif **12,** par exemple en p-InP, InP:Zn. Cette structure présente une interdiffusion **15** entre le In:Fe et le InP de type p, par exemple dopée au zinc.

La structure est pilotée par deux électrodes, une électrode inférieure **16** disposée sous le premier substrat **10** et une électrode supérieure **17** disposée sur la couche de confinement supérieur **14** de type p, afin d'amener le courant nécessaire au fonctionnement du modulateur. Si nécessaire, une couche conductrice de contact **18** est disposée entre la couche de confinement supérieur **14** et l'électrode métallique **17.** La couche semiconductrice de contact **18** peut être par exemple en InGaAs dopé p.

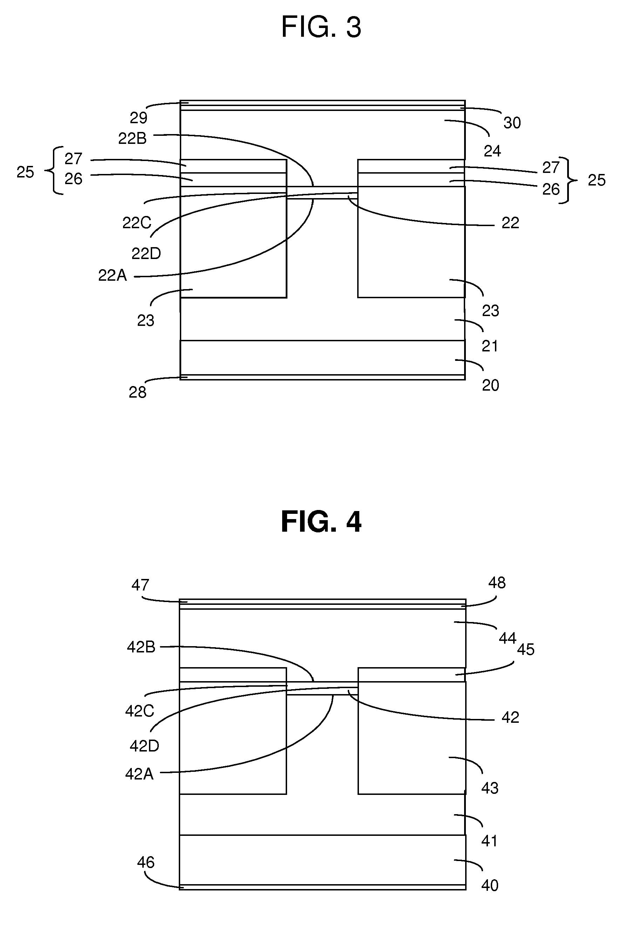

La figure 3 illustre un mode de réalisation de la section pilotée en courant d'une structure SIBH selon l'invention.

La structure SIBH comprend un substrat semiconducteur **20,** par exemple en n-InP ou SI-InP, qui est recouvert d'une couche de confinement inférieur **21** en n-InP dopé au silicium In:Si, la face inférieure de cette couche de confinement **21** reposant sur le substrat **20.** La couche de confinement **21** est surmontée d'un ruban **22** enterré en matériau actif d'émission laser qui, par exemple, peut être composé d'une seule couche ou d'un empilement de plusieurs couches formant une structure active dite à "puits quantiques".

Le ruban actif **22** comporte une face inférieure **22A** au contact de la couche de confinement **21,** une face supérieure **22B** qui lui est parallèle et deux faces latérales **22C** et **22D** qui sont perpendiculaires aux faces **22A** et **22B.** Des couches de confinement latéral semi-isolantes **23** sont au contact des faces **22C** et **22D** du ruban enterré **22.** Les couches de confinement latéral semi-isolantes **23** sont constituées par exemple d'une couche épaisse de InP:Fe (e.g. 1-10 µm). Une couche de confinement supérieur **24** en InP de type p recouvre la face supérieure **22B** du ruban enterré actif **22,** par exemple en p-InP, InP:Zn.

Une couche bloquante **25** est disposée de part et d'autre de la face supérieure **22B** du ruban enterré actif **22,** entre la couche semi-isolante de confinement latéral **23** et la couche de confinement supérieur **24.** La couche bloquante **25** limite l'interdiffusion des dopants entre les couches de confinement latéral **23** et supérieur **24.** La couche bloquante **25** est composée d'une couche mince **26** d'épaisseur inférieure à 1 µm en phosphure d'indium dopé au ruthénium InP:Ru qui est au contact des couches de confinement latéral **23.** La couche mince de InP:Ru **26** est recouverte d'une couche de matériau de type n **27** d'épaisseur inférieure à 0,5 µm comme par exemple n-GaInAsP.

La structure est pilotée par deux électrodes, une électrode inférieure **28** disposée sous le premier substrat **20** et une électrode supérieure **29** disposée sur la couche de confinement supérieur **24** de type p, afin d'amener le courant nécessaire au fonctionnement du laser. Pour réduire la résistivité de l'électrode supérieure **29,** une couche de contact **30** est disposée entre la couche de confinement supérieur **24** et l'électrode métallique **29.** La couche semiconductricede contact **30** peut être par exemple en InGaAs dopé p.

On considérera maintenant la figure 4 qui illustre un mode de réalisation de la section pilotée en tension d'une structure SIBH selon l'invention.

La structure SIBH comprend un substrat semiconducteur **40,** par exemple en n-InP ou SI-InP, qui est recouvert d'une couche de confinement inférieur **41** en n-InP dopé au silicium In:Si, la face inférieure de cette couche de confinement **41** reposant sur le substrat **40.** La couche de confinement inférieur **41** est surmontée d'un ruban enterré **42** en matériau actif de modulation. Le ruban actif **42** comporte une face inférieure **42A** au contact de la couche de confinement **41,** une face supérieure **42B** qui lui est parallèle et deux faces latérales **42C** et **42D** qui sont perpendiculaires aux faces **42A** et **42B.** Des couches de confinement latéral semi-isolantes **43** sont au contact des faces **42C** et **42D** du ruban enterré **42.** Les couches de confinement latéral semi-isolantes **23** sont constituées par exemple d'une couche épaisse de InP:Fe (e.g. 1-10µm). Une couche de confinement supérieur **44** en InP de type p recouvre la face **42B** du ruban enterré actif **42,** par exemple en p-InP, InP:Zn.

Une couche bloquante **45** est disposée de part et d'autre de la face supérieure **42B** du ruban enterré actif **42,** entre la couche semi-isolante de confinement latéral **43** et la couche de confinement supérieur **44.** La couche bloquante **45** limite l'interdiffusion des dopants entre les couches de confinement latéral **43** et supérieur **44.** La couche bloquante **45** est une couche mince en phosphure d'indium dopé au ruthénium InP:Ru d'épaisseur inférieure à 1 µm.

Ce mode de réalisation est basé sur la suppression de la couche bloquante de type n dans la section pilotée en tension en conservant un procédé simple d'une seule épitaxie pour le matériau semi-isolant et les couches bloquantes.

La structure est pilotée par deux électrodes, une électrode inférieure **46** disposée sous le premier substrat **40** et une électrode supérieure **47** disposée sur la couche de confinement supérieur **44** de type p, afin d'amener le courant nécessaire au fonctionnement du modulateur. Pour réduire la résistivité de l'électrode supérieure **47,** une couche de contact **48** est disposée entre la couche de confinement supérieur **44** et l'électrode supérieure **47** métallique. La couche semiconductrice de contact **48** peut être par exemple en InGaAs dopé p.

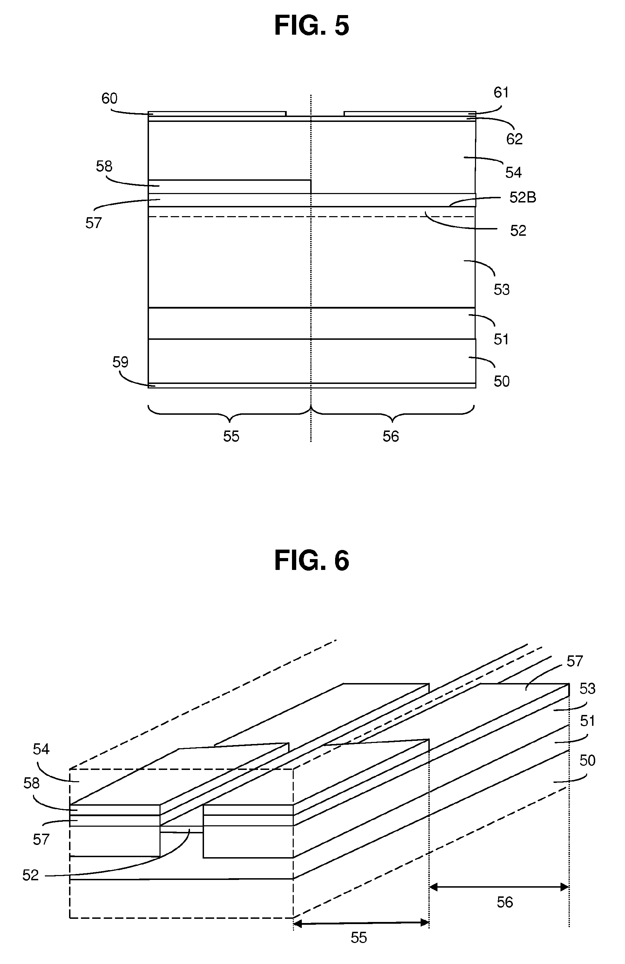

La figure 5 illustre une vue en coupe longitudinale des deux sections, pilotées respectivement en courant et en tension, du dispositif optoélectronique intégré à structure SIBH. La figure 6 illustre une vue en perspective des deux sections, pilotées respectivement en courant et en tension, du même dispositif optoélectronique.

La structure SIBH comprend un substrat semiconducteur **50,** par exemple en n-InP ou SI-InP, qui est recouvert d'une couche de confinement inférieur **51** en n-InP dopé au silicium In:Si, la face inférieure de cette couche de confinement **51** reposant sur le substrat **50.** La couche de confinement inférieur **51** est surmontée d'un ruban **52** enterré (non visible sur la figure) en matériau actif qui peut être composé d'une seule couche ou d'un empilement de plusieurs couches formant une structure active dite à "puits quantiques". Des couches de confinement latéral semi-isolantes **53** sont en contact avec les faces latérales du ruban enterré **52.** Les couches de confinement latéral **53** sont constituées par exemple d'une couche épaisse de InP:Fe (e.g. 1-10 µm). Une couche de confinement supérieur **54** en InP de type p recouvre la face supérieure **52B** du ruban enterré actif **52,** par exemple en p-InP, InP:Zn.

La structure SIBH comporte une section **55** pilotée en courant, par exemple une section d'émission laser, et une section **56** pilotée en tension, par exemple une section de modulation.

Dans la section **56** pilotée en tension, une couche bloquante **57,** composée seulement d'une couche mince en phosphure d'indium dopé au ruthénium InP:Ru, d'épaisseur inférieure à 1 µm, est disposée de part et d'autre de la face supérieure **52B** du ruban enterré actif **52,** entre la couche semi-isolante de confinement latéral 53 et la couche de confinement supérieur **54.**

Dans la section **55** pilotée en courant, la couche mince de InP:Ru **57** est recouverte d'une couche de matériau de type n **58,** d'épaisseur inférieure à 0,5 µm, comme par exemple le quaternaire n-GaInAsP.

Chaque section est pilotée par une paire d'électrodes, l'électrode inférieure pouvant être commune. Dans la section **55** pilotée en courant, une électrode inférieure **59** est disposée sous le substrat **50** et une électrode supérieure **60** est disposée sur la couche de confinement supérieur de type p **54,** afin d'amener le courant nécessaire au fonctionnement du laser. Dans la section **56** pilotée en tension, l'électrode inférieure **59** est disposée sous le substrat **50** et une électrode supérieure **61** est disposée sur la couche de confinement supérieur de type p **54,** afin d'amener le courant nécessaire au fonctionnement du modulateur. Pour réduire la résistivité des électrodes supérieures **60, 61,** une couche de contact **62** est disposée entre la couche de confinement supérieur **54** et l'électrode supérieure métallique **60, 61.** La couche semiconductrice de contact **62** peut être par exemple en InGaAs dopé p.

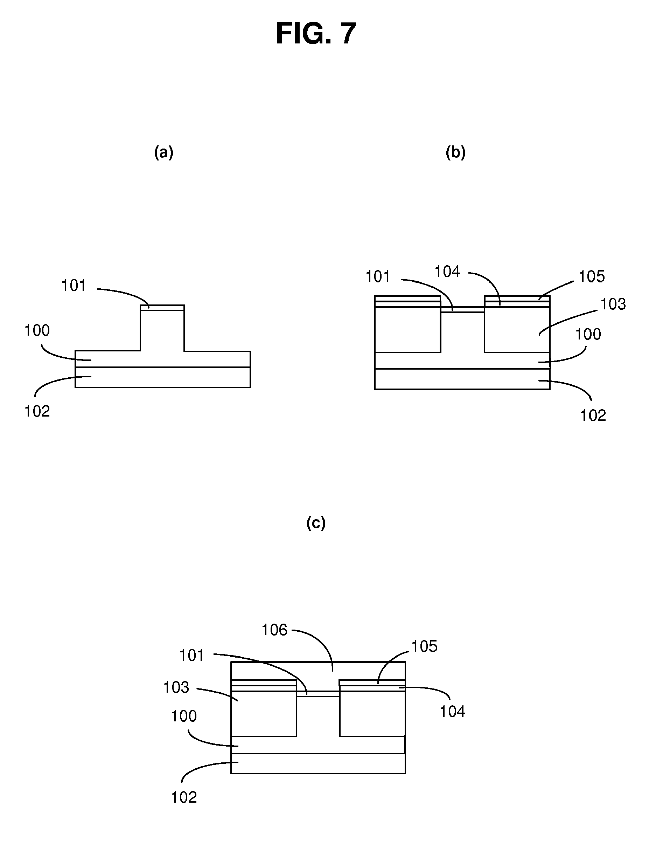

Sur les figures 7a, 7b et 7c, on a illustré le procédé de réalisation d'un dispositif optoélectronique intégré du type à laser et modulateur comportant au moins les étapes suivantes.

On réalise la couche de confinement inférieur **100** et le guide d'onde **101** sous forme d'un ruban enterré au moyen d'une première croissance épitaxiale sur le substrat **102,** suivie d'une gravure de la couche de confinement inférieur **100** et du ruban enterré **101** (figure 7a).

On réalise les couches de confinement latéral semi-isolantes **103,** les couches bloquantes **104** (InP:Ru) et **105** (dopée n) au moyen d'une seconde croissance épitaxiale. Les couches sont formées en empilement, l'une recouvrant l'autre. La deuxième couche bloquante dopée n **105** est réalisée sur toute la surface de la première couche bloquante InP:Ru **104.** Afin d'éviter une croissance épitaxiale sur le ruban enterré actif **101,** cette deuxième épitaxie est sélective, i.e. elle est effectuée en présence d'un masque de croissance placé sur le ruban enterré **101.**

On élimine la deuxième couche bloquante dopée n **105** dans la zone de la structure correspondant à la section de modulation. Avantageusement, cette étape est réalisée par gravure chimique ou bien par gravure sèche ou ionique (figure 7b).

On réalise la couche de confinement supérieure dopée p **106** au moyen d'une troisième croissance épitaxiale (figure 7c).

La réalisation des couches par croissance épitaxiale et leur délimitation par gravure chimique ou par gravure sèche ou ionique font partie des connaissances de l'homme du métier.

Avantageusement, le substrat, la couche de confinement supérieur, la couche de confinement latéral et la couche bloquante sont essentiellement réalisés dans un premier matériau semi-conducteur dont les composants appartiennent aux groupes III et V de la classification périodique. Bien entendu les matériaux et éléments dopants mentionnés le sont à titre d'exemple, et des structures III-V différentes peuvent être réalisées en utilisant le même principe de SIBH.

Bien entendu, la présente invention n'est pas limitée aux modes de réalisation décrits, mais elle est susceptible de nombreuses variantes accessibles à l'homme de l'art sans que l'on s'écarte de l'esprit de l'invention. En particulier, l'invention s'applique à tout type de matériau III-V. L'élément III est notamment choisi parmi l'aluminium, le gallium et l'indium et l'élément V est choisi parmi le phosphore, l'arsenic ou l'antimoine. En outre, les couches semi-conductrices peuvent être en matériau binaire, ternaire ou quaternaire. Le substrat peut par exemple être en GaAs ou InP. L'invention s'applique également au domaine de la microélectronique sur InP.

## Revendications

1. Dispositif optoélectronique intégré de structure de type SIBH comprenant au moins une section pilotée en courant et une section pilotée en tension, la section pilotée en courant comportant une couche bloquante entre le matériau InP dopé au fer (InP:Fe) et le matériau InP de type p (p-InP), **caractérisé en ce que** la couche bloquante comprend une première couche de matériau InP dopé au ruthénium (InP:Ru) d'épaisseur inférieure à 1 µm et une deuxième couche de matériau de type n d'épaisseur inférieure à 0,5 µm.

2. Dispositif optoélectronique selon la revendication 1, dans lequel la section pilotée en tension comporte une couche bloquante entre le matériau InP dopé au fer (InP:Fe) et le matériau InP de type p (p-InP), la couche bloquante comprenant une couche de matériau InP dopé au ruthénium (InP:Ru) d'épaisseur inférieure à 1 µm.

3. Dispositif optoélectronique selon la revendication 1, dans lequel la deuxième couche de matériau de type n est en InGaAsP (Indium-Gallium-Arsenic-Phosphore).

4. Dispositif optoélectronique selon la revendication 1, dans lequel la deuxième couche de matériau de type n a un réseau cristallin adapté au réseau cristallin du matériau du substrat.

5. Procédé de fabrication d'un dispositif optoélectronique selon l'une des revendications précédentes, comprenant les étapes suivantes:
- réalisation d'une couche de confinement inférieur et d'un guide d'onde au moyen d'une première croissance épitaxiale sur un substrat, suivie d'une gravure de la couche de confinement inférieur et du guide d'onde,
- réalisation de l'empilement d'une couche de confinement latéral, d'une première couche de matériau InP:Ru et d'une deuxième couche de matériau p-InP au moyen d'une seconde croissance épitaxiale,
- élimination de la deuxième couche de matériau de type n dans la zone de la structure correspondant à la section pilotée en tension,
- réalisation d'une couche de confinement vertical dopée p au moyen d'une troisième croissance épitaxiale.

6. Procédé de fabrication selon la revendication 4, dans lequel l'élimination de la deuxième couche de matériau de type n dans la section de modulation est réalisée par gravure chimique ou ionique.
